Europäisches Patentamt

European Patent Office

Office européen des brevets

(19)

(11) Publication number: **0 097 977**
**B1**

## EUROPEAN PATENT SPECIFICATION

(12)

(45) Date of publication of patent specification: **26.11.86**

(51) Int. Cl.⁴: **H 03 K 23/68,** G 06 F 7/68

(21) Application number: **83200684.5**

(22) Date of filing: **11.02.81**

(80) Publication number of the earlier application in accordance with Art. 76 EPC: **0 035 334**

(54) **Frequency synthesizer.**

(30) Priority: **11.02.80 US 120272**
**11.02.80 US 120271**
**11.02.80 US 120291**
**11.02.80 US 120292**

(43) Date of publication of application:
**11.01.84 Bulletin 84/02**

(45) Publication of the grant of the patent:
**26.11.86 Bulletin 86/48**

(84) Designated Contracting States:
**CH DE FR GB IT LI NL SE**

(56) References cited:
**DE-A-1 958 662**
**DE-A-2 510 766**
**US-A-3 217 267**
**US-A-4 081 755**
**US-A-4 084 082**

(73) Proprietor: **DATA GENERAL CORPORATION**
**Route 9**
**Westboro Massachusetts 01581 (US)**

(72) Inventor: **Bernstein, David H.**
**41 Bay Colony Drive**
**Ashland Massachusetts 01721 (US)**
Inventor: **Carberry, Richard A.**
**23965 Glenwood Drive**
**Los Gatos California 95030 (US)**
Inventor: **Druke, Michael B.**
**32 Longmeadow Road**
**Chelmsford Massachusetts 01824 (US)**
Inventor: **Gusowski, Ronald I.**
**5 Baxter Street**
**Westboro Massachusetts 01581 (US)**
Inventor: **Buckley, Edward M.**
**68 Dutcher Street**
**Hopedale Massachusetts 01747 (US)**
Inventor: **March, Roger W.**
**3422 Georgetown Place**
**Santa CLara California 95051 (US)**

(74) Representative: **Pears, David Ashley et al**
**REDDIE & GROSE 16 Theobalds Road**
**London WC1X 8PL (GB)**

EP 0 097 977 B1

Courier Press, Leamington Spa, England.

## Description

The present invention relates to a frequency synthesizer for dividing an input signal by a non-integral divisor such as to produce an output signal of predetermined mean frequency, as set forth in the introductory part of claim 1. Such a synthesizer may be used in a data processing system to provide a constant frequency clock signal from a plurality of different input frequencies.

For example, a data processing system may include an input/output (I/O) interface unit which utilizes one or more counter signals, each of which has a substantially constant frequency and is derived from a system input clock signal. The system I/O interface unit, however, may receive a system input clock signal which has any one of a plurality of different but known, frequencies. Accordingly, such a unit can include a frequency synthesizer which can respond to any of the plurality of different frequency input signals and can still derive the desired one of more counter signals therefrom at the desired substantially constant frequencies involves.

A frequency synthesizer of the type set forth above is known from DE 2 510 766 which uses feedback to preset comparators to select between the two consecutive integer divisors.

Another frequency synthesizer is known from US 2 317 267 in which high and low divisor integers (for the special case of a major cycle always consisting of 10 counter cycles) are selected in an interspersed manner using diode matrices. US 4 084 082 uses fixed high and low divisors and repeatedly counts A divisions by the high divisor followed by B divisions by the low divisor, the values of A and B being read out of a read-only memory.

The first and second references mentioned above utilize relatively complex and dedicated circuitry. Although the third reference uses a read-only memory to provide the values of A and B, it is otherwise inflexible as the divisors are restricted to 10 and 11. The object of the present invention is to provide a frequency synthesizer with improved control logic which takes full advantage of the facilities offered by read-only memories to give complete flexibility over the choice of the consecutive integers and the scheme according to which they are interspersed, so that the same circuit can be set up (by read-only memory contents) to establish virtually any desired non-integral divisor.

The frequency synthesizer according to the invention is defined in the characterising part of claim 1.

The invention will now be described in more detail, by way of example, with reference to the accompanying drawings, in which:

Fig. 1 is a block diagram of a frequency synthesizer unit;

Fig. 2 is a chart which depicts a parsing algorithm used for the operation of the frequency synthesizer of Fig. 1; and

Fig. 3 is a timing diagram showing how the synthesizer output signal is generated from two different input signals.

The frequency synthesizer may be used in a system I/O unit such as that described in EP 0 035 334 (and in application No. 83200686.0 which, like the present application, is divided out of 81300560, published as EP 0 035 334).

The system I/O interface unit is designed so as to be capable of operation at more than one input system clock frequency and is, therefore, adaptable for use with a system wherein the system clock is not expected to remain at a single fixed frequency for all operations. The frequency synthesizer unit is provided so as to be reponsive to one of a plurality of different selected input frequencies to produce the desired internal clock frequency required for operation of the internal devices of the interface unit and the desired master baud rate signal for operation of the asynchronous terminal system. In a particular embodiment, for example, the internal clock signal must have a substantially constant frequency of 1 MHz so as to provide for correct operation of the internal, or local, devices (such as a programmed interval timer or a real time clock), and a substantially constant selected baud rate derived from a substantially constant master baud rate signal for the asynchronous terminal input/output logic.

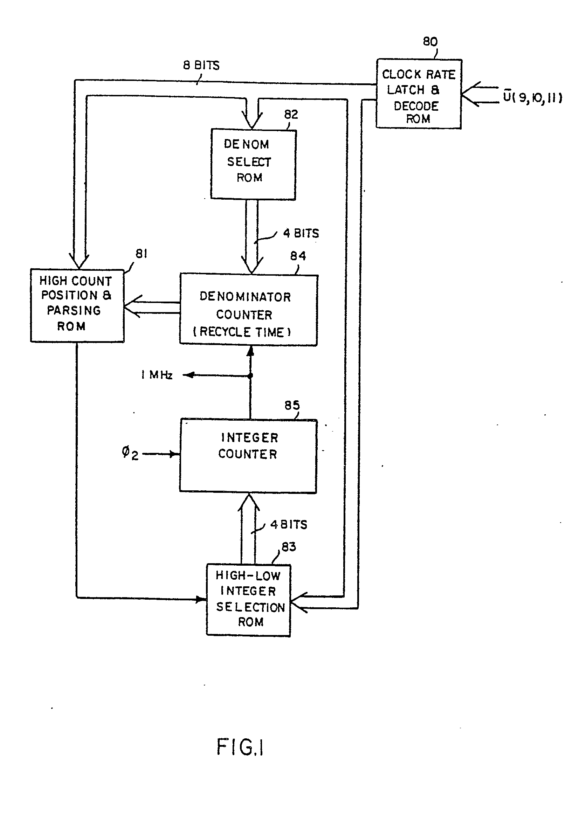

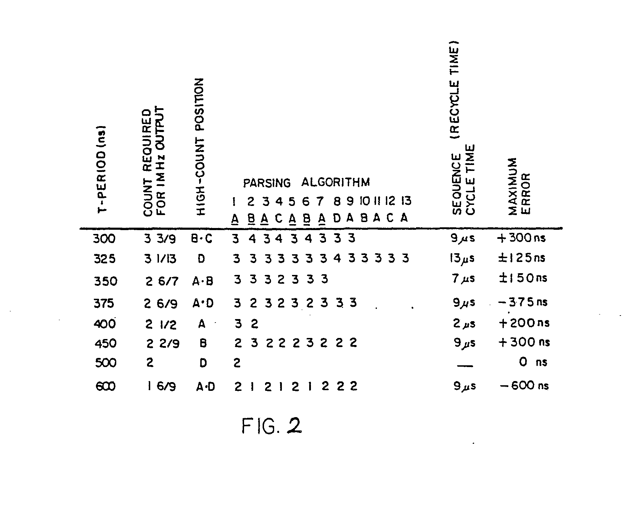

The apparatus for effecting such frequency synthesis is shown in Fig. 1. In a particular embodiment thereof, the clock rate of the selected input clock signal $\emptyset_2$ to the frequency synthesizer unit may be one of eight different clock signals having clock periods which vary from 300 nanoseconds (nS) to 600 nanoseconds (see chart of Fig. 2). For example, in a particular embodiment eight different signals having clock periods, T, of 300 nS, 325 nS, 350 nS, 375 nS, 400 nS, 450 nS, 500 nS and 600 nS are utilized. The input frequency is identified by a 3-bit input signal on an internal bus $\overline{U}$ of the I/O interface unit, namely as $\overline{U}$-bus bits $\overline{U}$ 9, 10, 11. This signal is supplied to a clock rate latch and decode ROM 80, which identifies which of the eight clock rates must be latched for supply to the frequency synthesizer. The selected clock rate so latched is supplied to a high-count position and parsing ROM 81, to a denominator select ROM 82, and a high-low integer select ROM 83. The functions thereof can be understood better with the help of an example explained with reference to the chart of Fig. 2.

This chart depicts an example of the above frequency synthesizer technique for generating the pseudo-constant 1.0 MHz output clock for each of the eight different input clock signals.

As can be seen therein, except for the 500 nS clock signal, the clock periods for each of the eight frequencies involved are non-integral multiples of the clock period for the desired 1.0 MHz signal. For example, an input clock signal having a 350 nS clock period completes 2 6/7 periods in the total 1000 nS clock period of 1.0 MHz signal. Thus, for every 2 6/7 clock pulses of the 350 nS input clock signal, one clock pulse must be produced for the 1.0 MHz output clock signal, i.e., for any 20 input clock pulses, 7 output clock pulses are produced.

The chart of Fig. 2 depicts the parsing algorithm associated with each of the input clock signals. As can be seen therein, groups of input clock pulses are produced over repeatable or recycle time intervals the number of pulses in each group being selected as one of two numbers. Thus, for an input clock signal having a 350 nS period, seven groups of input pulses are utilized having either 3 pulses (high counts) or 2 pulses (low count). The position of the high count groups is depicted by the "high-count position" column in accordance with the lettered column of the algorithm. Thus, the high count (3-pulse) groups are at the A and B positions of the seven group cycle (the low count group being at position C) so that the seven groups are as follows:

3 3 3 2 3 3 3

It should be noted that the non-integral count (i.e., 2 6/7) identifies the algorithm to be used. Thus for the 350 nS input clock, the low/high counts vary between "2" (the whole number) and "3" (the next highest integer). The numerator of the fraction identifies the number of high-count position groups (i.e., "6" high count position groups), and the denominator identifies the total number of position groups ("7" position groups), sometimes referred to as the recycle time period. As another example the 300 nS clock signal requires a count of 3 3/9 and utilizes low/high counts of "3" and "4", a recycle time period (the denominator of the fraction) of "9" (i.e., 9 groups), three of which groups (the numerator of the fraction) are "high count" groups. The 3 high-count groups are placed in positions B and C. The other algorithms can be similarly described. In Fig. 1 the denominator select ROM 82 selects the appropriate denominator, or recycle time period, depending on which input clock RATE has been latched, the selected denominator (i.e., "7" for the 350 nS input clock) being identified by a 4-bit output of ROM 82. The ROM 81 identifies which of the eight parsing algorithms shown in the chart of Fig. 2 is to be used. In the example being discussed the parsing algorithm A.B. representing seven groups of 350 nS pulses having 3 3 3 2 3 3 3 pulses in each group is selected.

It should be noted that in each parsing algorithm one of two numbers of pulses is used in each group. Thus, for the 350 nS algorithm either 3 pulses (the high count) or 2 pulses (the low count) are used, in the 300 nS algorithm either 4 pulses (the high count) or 3 pulses (the low count) are used. The parsing ROM 81 effectively determines for each denominator count from denominator counter 84 which of the pulse counts (high or low) is to be used. Thus, for the 350 nS clock the parsing ROM 81 determines that the high count (3) is selected for the first three and the last three of the seven denominator counts and that the low count (2) is selected from the middle denominator count in the overall recycle counter period.

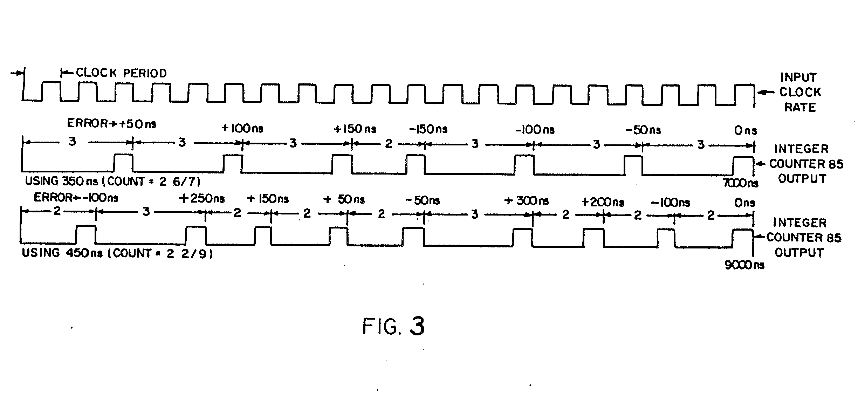

The high or low integer is then selected by high-low integer select ROM 83 to identify which of the counts on integer counter 85 must count so in order to supply one output pulse therefrom for each of the seven groups (i.e, whether the group contains three 350 nS pulse counts or two 350 nS pulse counts) so that for every 7 groups (making up 20 350 nS pulses in total) seven output pulses are supplied. Accordingly, as seen in the timing diagram of Fig. 3, the output of integer counter 85 is a 1 MHz clock signal, i.e., every 7000 nS (20×350 nS) the output counter 85 produces 7 pulses which is, of course, equivalent to one pulse every 1000 nS. A similar analysis is shown in Fig. 3 for the 450 nS input clock and can be made for each of the eight input clocks and associated parsing algorithms shown in the chart of Fig. 11.

As can be seen in Fig. 3 for the 350 nS input clock, while the pulse spacing of the output signal is not uniform, the number of pulses over each seven microseconds (i.e., 7000 nanoseconds) recycle time period is the same. Thus, while a timing error may occur during each recycle time period the error reduces to zero at the end thereof. For the 350 nS clock signal the maximum error which occurs during the recycle period is ±150 nS, as shown in Fig. 3, and the error at the end of the recycle period is zero. For the 450 nS input signal maximum error is 300 nS and at the end of the recycle time period of 9000 nS, the error is zero. The maximum error for all of the input clock signals are shown in the chart of Fig. 2. Such errors are of little significance over the time periods required for operation of the internal units which utilize the 1 MHz signal so that for all practical purposes, the 1 MHz signal has an essentially constant frequency. It should be noted that in no case is the maximum error greater than the time period of the input clock signal involved.

The above frequency synthesis unit provides an extremely adaptable system I/O interface unit which can supply the desired master clock signal for the local or internal devices and the desired master baud rate signal for asynchronous terminal operation even when the system input clock signal has one of a plurality of different selectable frequencies. The overall frequency synthesizer circuitry includes substantially two versions of the general unit shown in Fig. 1, one for the 1.0 MHz output signal and one for the master baud rate output. A baud rate selection circuit can be utilized to provide one of a plurality of 16 different baud rates from the master baud rate by suitable baud selection circuitry which provides integer multiples of the master baud rate as desired. The circuitry for dividing the master baud rate to obtain each of 16 different baud rates is well known to those in the art. Moreover, the 1.0 MHz clock rate can also be appropriately divided down to produce clock rates which are integer submultiples of the 1.0 MHz master clock rate for various internal devices as required. Lists of the exemplary baud rates which can be derived from a master baud rate of 614,000 Hz and exemplary local counter output signals (decode counter clocks) which can be derived from a master 1.0 MHz clock signal are provided below.

| Baud rates | Local counter output signals |
|---|---|
| 50 | 1.0 MHz |
| 75 | 100 KHz |
| 110 | 10 KHz |
| 134.5 | 1.0 KHz |
| 150 | |
| 200 | |
| 300 | |
| 600 | |
| 1200 | |
| 1800 | |
| 2000 | |
| 2400 | |
| 4800 | |
| 9600 | |
| 19200 | |
| 38400 | |

## Claims

1. A frequency synthesizer for dividing an input signal ($\emptyset_2$) by a non-integral divisor comprising an integer part and fractional part smaller than ·one such as to produce an output signal (1 MHz) of predetermined mean frequency, comprising a first counter (85) for selectively dividing by first and second consecutive integers with the first integer corresponding to the integer part of the divisor, and control logic (80—84) which includes a second counter (84) and cuuses the first counter (85) to repeatedly effect a major cycle of counts consisting of a first number of counts of the first integer interspersed among a second number of counts of the second integer the second counter (84) cyclically counting the count cycles of the first counter (85) in the said major cycle up to a total number of such count cycles in the said major cycle, the second number corresponding to the numerator of the fractional port and the total number corresponding to the denominator, characterised in that the control logic comprises first, second and third read-only memories (82, 83 and 81), addressing means (80) responsive to a selection signal (U) denoting the non integral divisor for addressing the memories, the total number is provided to the second counter (84) by the first read-only memory (82), the second read-only memory (83) is addressed by the addressing means (80) for outputting a selected pair of first and second consecutive integers the third read-only memory (81) being responsive both to the addressing means (80) and to the state of the second counter (84) to provide a control signal selecting between a high integer and a low integer, and the second read-only memory (83) is responsive to the control signal to select which of the pair of integers is output to the first counter (85) to determine the count cycle thereof.

2. A frequency synthesizer according to claim 1, characterised in that successive counts of the second counter (84) are associated with a pattern of interspersed count positions (A, B, C etc.), the third read-only memory (81) is responsive to the addressing means (80) to determine whether each such count position corresponds to the control signal high or the control signal low, and the pattern of interspersed count positions is such that the maximum instantaneous timing error in the output signal (1 MHz) does not exceed the period of the input signal ($\emptyset_2$).

3. A frequency synthesizer according to claim 1 or 2, characterised in that the addressing means (80) is a further read-only memory decoding the selection signal (U) to provide address signals to the first, second and third read-only memories (82, 83, 81).

## Patentansprüche

1. Frequenzsynthetizer zur Teilung eines Eingangssignals ($\emptyset_2$) durch einen nicht ganzzahligen Teiler, der einen ganzzahligen Teil und einen Bruchteil kleiner als Eins aufweist, um ein Ausgangssignal (1 MHz) vorgewählter Durchschnittsfrequenz zu erhalten, enthaltend einen ersten Zähler (85) zum wahlweisen Teilen durch eine erste ganze Zahl und eine darauf folgende zweite ganze Zahl, von denen die erste dem ganzzeiligen Teil des·Teilers entspricht, und eine Steuerlogik (8—84), die einen zweiten Zähler (84) aufweist und den ersten Zähler (85) veranlaßt, wiederholt einen größeren Zyklus von Zählungen zu durchlaufen, der aus einer ersten Anzahl von Zählungen der ersten ganzen Zahl besteht, die zwischen einer zweiten Anzahl von Zählungen der zweiten ganzen Zahl verschachtelt angeordnet sind, wobei der zweite Zähler (84) zyklisch die Zählungszyklen des ersten Zählers (85) innerhalb des besagten größeren Zyklus von Zählungen bis herauf zu einer Gesamtzahl derartiger Zählungszylken in dem größeren Zyklus zählt und wobei die zweite Anzahl dem Zähler des Bruchteils und die Gesamtzahl dem Nenner entspricht, dadurch gekennzeichnet, daß die Steuerlogik einen ersten, zweiten und dritten ROM-Speicher (82, 83 und 81) und eine Adressiereinrichtung (80) zur Adressierung der ROM-Speicher aufweist, die auf ein Selektionssignal (U) anspricht, das den nicht ganzzahligen Teiler bezeichnet, wobei die Gesamtzahl dem zweiten Zähler (84) durch den ersten ROM-Speicher (82) zugeführt wird, der zweite ROM-Speicher (83) durch die Adressiereinrichtung (80) adressiert wird, um ein gewähltes Paar von ersten und zweiten aufeinanderfolgenden ganzen Zahlen abzugeben, der dritte ROM-Speicher (81) sowohl auf die Adressiereinrichtung (80) als auch auf den Zustand des zweiten Zählers (84) unter Erzeugung eines Steuersignals entspricht, des zwischen einer hohen und niedrigen ganzen Zahl auswählt, und der zweite ROM-Speicher (83) auf das Steuersignal anspricht und auswählt, welche des Paars von ganzen Zahlen der Ausgang für den ersten Zähler (85) ist, um dessen Zählungszyklus festzulegen.

2. Frequenzsynthetizer nach Anspruch 1, dadurch gekennzeichnet, daß aufeinanderfolgende Zählungen des zweiten Zählers (84) einem Muster von verschachtelt angeordneten Zählstellungen (A, B, C usw.) zugeordnet sind, der dritte ROM-Speicher (81) auf die Adressiereinrichtung (80) anspricht, um festzustellen, ob jede dieser Zählstellungen dem Steuersignal Hoch oder dem Steuersignal Tief entspricht, und das Muster der verschachtelt angeordneten Zählstellungen derart ist, daß der maximale augenblickliche Zeitfehler im Ausgangssignal (1 MHz) nicht die Periode des Eingangssignals ($\emptyset_2$) übersteigt.

3. Frequenzsynthetizer nach Anspruch 1 oder 2, dadurch gekennzeichnet, daß die Adressiereinrichtung (80) ein weiterer ROM-Speicher ist, der das Selektionssignal (U) dekodiert, um Adressensignale für den ersten, zweiten und dritten ROM-Speicher (82, 83, 81) zu erzeugen.

## Revendications

1. Synthétiseur de fréquence pour diviser un signal d'entrée $\emptyset_2$ par un diviseur non-entier comprenant une partie entière et une partie fractionnelle inférieure à un de façon à produire un signal de sortie (1 MHz) de fréquence moyenne prédéterminée, comprenant un premier compteur (85) pour diviser sélectivement, par des premier et second entiers consécutifs, le premier entier correspondant à la partie entière du diviseur, et une logique de commande (80—84) qui comprend un second compteur (84) et amène le premier compteur (85) à effectuer de façon répétée un cycle principal de comptage consistant en un premier nombre de comptages du premier entier intercalés parmi un second nombre de comptages du second entier, le second compteur (84) comptant de façon cyclique le cycles de comptage du premier compteur (85) dans le cycle principal jusqu'à un nombre total de tels cycles de comptage dans le cycle principal, le second nombre correspondant au numérateur de la partie fractionnelle et le nombre total correspondant au dénominateur, caractérisé en ce que la logique de commande comprend des première, seconde et troisième mémoires mortes (82, 83 et 81), un moyen d'adressage (80) agissant en réponse à un signal de sélection (U) désignant le diviseur non entier pour adresser des mémoires, en ce que le nombre total est fourni au second compteur (84) par la première mémoire morte (82), en ce que la seconde mémoire morte (83) est adressée par le moyen d'adressage (80) pour fournir une paire choisie de premier et second entiers consécutifs, la troisième mémoire morte (81) agissant en réponse au moyen d'adressage (80) et à l'état du second compteur (84) pour fournir un signal de commande choisissant entre un entier haut et un entier bas, et en ce que la seconde mémoire morte (83) agit en réponse au signal de commande pour choisir lequel dans la paire d'entiers est fourni au premier compteur (85) pour déterminer son cycle de comptage.

2. Synthétiseur de fréquence selon la revendication 1, caractérisé en ce que des comptages successifs du second compteur (84) sont associés à un diagramme de positions de comptage intercalées (A, B, C, etc.), en ce que la troisième mémoire morte (81) agit en réponse au moyen d'adressage (80) pour déterminer si chaque telle position de comptage correspond au signal de commande haut ou au signal de commande bas, et en ce que le diagramme de position de comptage intercalée est tel que l'erreur de synchronisation instantanée maximale dans le signal de sortie (1 MHz) ne dépasse pas la période du signal d'entrée ($\emptyset_2$).

3. Synthétiseur de fréquence selon l'une des revendications 1 ou 2, caractérisé en ce que le moyen d'adressage (80) est une autre mémoire morte décodant le signal de sélection (U) pour fournir des signaux d'adresses aux première, seconde et troisième mémoires mortes (82, 83, 81).

FIG.1

| T-PERIOD (ns) | COUNT REQUIRED FOR 1MHz OUTPUT | HIGH-COUNT POSITION | PARSING ALGORITHM 1 2 3 4 5 6 7 8 9 10 11 12 13 A B A C A B A D A B A C A | | | | | | | | | | | | | SEQUENCE (RECYCLE TIME) CYCLE TIME | MAXIMUM ERROR |
|---|---|---|---|---|---|---|---|---|---|---|---|---|---|---|---|---|---|
| 300 | 3 3/9 | B·C | 3 | 4 | 3 | 4 | 3 | 4 | 3 | 3 | 3 | | | | | 9 μs | + 300 ns |
| 325 | 3 1/13 | D | 3 | 3 | 3 | 3 | 3 | 3 | 3 | 4 | 3 | 3 | 3 | 3 | 3 | 13 μs | ± 125 ns |
| 350 | 2 6/7 | A·B | 3 | 3 | 3 | 2 | 3 | 3 | 3 | | | | | | | 7 μs | ± 150 ns |
| 375 | 2 6/9 | A·D | 3 | 2 | 3 | 2 | 3 | 2 | 3 | 3 | 3 | | | | | 9 μs | − 375 ns |
| 400 | 2 1/2 | A | 3 | 2 | | | | | | | | | | | | 2 μs | + 200 ns |
| 450 | 2 2/9 | B | 2 | 3 | 2 | 2 | 2 | 3 | 2 | 2 | | | | | | 9 μs | + 300 ns |
| 500 | 2 | D | 2 | | | | | | | | | | | | | — | 0 ns |
| 600 | 1 6/9 | A·D | 2 | 1 | 2 | 1 | 2 | 1 | 2 | 2 | | | | | | 9 μs | − 600 ns |

FIG. 2

FIG. 3

0 097 977